# EUROPÄISCHE PATENTANMELDUNG

(11) **EP 3 199 960 A1**
(43) Veröffentlichungstag der Anmeldung: **02.08.2017**
(21) Anmeldenummer: 16153148.8
(22) Anmeldetag: 28.01.2016
(51) Int. Cl.: G01R 31/02, G01R 31/28

(54) **SCHALTUNGSANORDNUNG, ANALOG-EINGABEBAUGRUPPE UND VERFAHREN ZUR DRAHTBRUCHPRÜFUNG**

(71) Anmelder: Siemens Aktiengesellschaft, 80333 München (DE)
(72) Erfinder: Prochaska, Dirk, 09127 Chemnitz (DE)

(57) **Zusammenfassung**

Die Erfindung betrifft eine Schaltungsanordnung (1) mit einem Analog-Digital-Umsetzer (2) zur Umsetzung eines analogen Empfangssignals (y(t)) in ein digitales Empfangssignal (y(n)), weiterhin aufweisend eine erste Eingangsklemme (E1) und eine zweite Eingangsklemme (E2) zum Anschluss eines Messumformers (M1,M2), wobei zwischen der ersten Eingangsklemme (E1) und der zweiten Eingangsklemme (E2) eine steuerbare Stromquelle (5) angeordnet ist, dabei steht die Stromquelle (5) mit einem Testsignalgenerator (10) in Verbindung, welcher auf Basis eines digitalen Testsignals (x(n)) die Stromquelle (5) derart steuert, dass die Stromquelle (5) über die Eingangsklemmen (E1,E2) ein analoges Sendesignal (x(t)) ausgibt, weiterhin aufweisend ein Signalanalysemittel (12), welches einen ersten Analyseeingang (21) und einen zweiten Analyseeingang (22) aufweist, dabei ist auf den ersten Analyseeingang (21) das digitale Empfangssignals (y(n)) und auf den zweiten Analyseeingang (22) das digitale Testsignal (x(n)) geschaltet, das Signalanalysemittel (12) ist ausgestaltet auf die an den Analyseeingängen (21,22) anliegenden Signale eine Kreuzkorrelationsfunktion (R_{xy}) anzuwenden und einen Funktionswert (K(t)) zu ermitteln, weiterhin ist das Signalanalysemittel (12) ausgestaltet an Hand des Funktionswertes (K(t)) zu prüfen, ob das analoge Sendesignal (x(t)) in dem analogen Empfangssignal (Y(t)) enthalten war, und für den Fall, dass das analoge Sendesignal (x(t)) nicht in dem analogen Empfangssignal (Y(t)) enthalten war, ein Fehlersignal (DB) auszugeben.

## Beschreibung

Die Erfindung betrifft eine Schaltungsanordnung mit einem Analog-Digital-Umsetzer zur Umsetzung eines analogen Empfangssignals in ein digitales Empfangssignal.

Des Weiteren betrifft die Erfindung eine Analog-Eingabebaugruppe zur Umsetzung eines analogen Empfangssignals in ein digitales Empfangssignal.

Auch betrifft die Erfindung ein Verfahren zur Erkennung eines Drahtbruches von einer Leitung.

Zur Drahtbrucherkennung wird gewöhnlich ein Gleichstrom benutzt. Insbesondere bei Analog-Eingabebaugruppen zur Umsetzung eines analogen Empfangssignals in ein digitales Empfangssignal mit einem vorgeschalteten Multiplexer gibt es eine Forderung an eine erhöhte Gleichtaktfestigkeit, welches bedeutet, dass sich hohe Spannungsunterschiede und Potentialausgleichsvorgänge beim Umschalten der Schalter des Multiplexers nicht störend bemerkbar machen. Um diese erhöhte Gleichtaktfestigkeit zu erfüllen, werden in dem Multiplexer Widerstände im Megaohm-Bereich in eine Messschleife geschaltet. Das bisher bewährte Verfahren zur Drahtbrucherkennung mit der Gleichstrommessung versagt aber nun, da die Widerstände zu hochohmig sind und die daraus resultierenden Ströme sehr klein werden.

Es ist Aufgabe der vorliegenden Erfindung eine Schaltungsanordnung, insbesondere eine Analog-Eingabebaugruppe und ein Verfahren dafür bereitzustellen, bei welchen trotz der nun eingefügten Widerstände im Megaohm-Bereich sicher eine Drahtbrucherkennung durchgeführt werden kann.

Die Aufgabe wird durch eine Schaltungsanordnung gelöst, wobei die Schaltungsanordnung einen Analog-Digital-Umsetzer zur Umsetzung einen analogen Empfangssignals in ein digitales Empfangssignal aufweist, weiterhin aufweisend eine erste Eingangsklemme und eine zweite Eingangsklemme zum Anschluss eines Messumformers, wobei zwischen der ersten Eingangsklemme und der zweiten Eingangsklemme eine steuerbare Stromquelle angeordnet ist, dabei steht die Stromquelle mit einem Testsignalgenerator in Verbindung, welcher auf Basis eines digitalen Testsignals die Stromquelle derart steuert, dass die Stromquelle über die Eingangsklemmen ein analoges Sendesignal ausgibt, weiterhin aufweisend ein Signalanalysemittel, welches einen ersten Analyseeingang und einen zweiten Analyseeingang aufweist, dabei ist auf den ersten Analyseeingang das digitale Empfangssignal und auf den zweiten Analyseeingang das digitale Testsignal geschaltet, das Signalanalysemittel ist ausgestaltet, auf die an den Analyseeingängen anliegenden Signale eine Kreuzkorrelationsfunktion anzuwenden und einen Funktionswert zu ermitteln, weiterhin ist das Signalanalysemittel ausgestaltet, anhand des Funktionswertes zu prüfen, ob das analoge Sendesignal in dem analogen Empfangssignal enthalten war, und für den Fall, dass das analoge Sendesignal nicht in dem analogen Empfangssignal enthalten war, ein Fehlersignal auszugeben.

Um trotz der Widerstände im Megaohm-Bereich weiterhin sicher einen Drahtbruch detektieren zu können, wird beispielsweise vor einer Messung eines analogen Empfangssignals ein harmonisches Burstsignal aufgeschaltet, welches später zur Detektion benutzt wird. Da dieses harmonische Burstsignal ebenfalls durch die hohen Widerstände abgeschwächt, oder sogar im Rauschen verschwinden kann, wird aus diesem Burstsignal und dem Empfangssignal eine Kreuzkorrelation gebildet. Die Kreuzkorrelation wiederum liefert ein sauber zu detektierendes Signal. Die Kreuzkorrelation liefert die Aussage, ob das harmonische Burstsignal im Empfangssignal enthalten ist. Ist dies der Fall, so erhält man als Korrelationsergebnis wiederum ein harmonisches Signal. Im Falle eines Drahtbruches sinkt eine Amplitude des ermittelten Kreuzkorrelationssignals stark ab und ändert seine Signalform. Im einfachsten Falle reicht eine Erkennung der Maximalamplitude in dem Kreuzkorrelationsergebnis von dem harmonischen Burstsignal. Man ist also in der Lage, nun niederpegelige harmonische Signale im Empfangssignal zu erkennen.

In einer weiteren Ausgestaltung weist der Analog-Digital-Umsetzer der Schaltungsanordnung einen ersten Eingang, einen zweiten Eingang und einen Ausgang auf und die Stromquelle ist in einer Reihenschaltung mit einen Messwiderstand zwischen den Eingangsklemmen angeordnet, wobei der erste Eingang über ein Schaltmittel mit der ersten Eingangsklemme in Verbindung steht, dabei ist das Schaltmittel ausgestaltet, während einer Testphase zur Ausgabe des analogen Sendesignals den ersten Eingang mit einem Mittenabgriff zwischen dem Messwiderstand und der Stromquelle zu verbinden und während einer Messphase, bei welcher Messwerte des Messumformers ermittelt werden, den ersten Eingang mit der ersten Eingangsklemme zu verbinden.

Weiterhin ist die Schaltungsanordnung ausgestaltet mit einer Steuereinheit, welche ausgestaltet ist das Schaltmittel entsprechend der Testphase oder der Messphase zu steuern.

Um eine derartige Schaltungsanordnung für mehrere Messumformer zu nutzen, ist an den Eingangsklemmen eine Selektionsschaltung angeschlossen, welche ausgestaltet ist, einen ersten Kanal oder einen zweiten Kanal mit den Eingangsklemmen zu verbinden.

Insbesondere in der industriellen Automatisierungstechnik werden zum Erfassen von analogen Messsignalen Analog-Eingabebaugruppen zur Umsetzung eines analogen Empfangssignals in ein digitales Empfangssignal eingesetzt.

Die eingangs genannte Aufgabe wird ebenso durch eine Analog-Eingabebaugruppe zur Umsetzung eines analogen Empfangssignals in ein digitales Empfangssignal gelöst, wobei die Analog-Eingabebaugruppe eine Selektionsschaltung aufweist, welche ausgestaltet ist, einen ersten Kanal oder einen zweiten Kanal mit jeweils einer ersten Eingangsklemme und einer zweiten Eingangsklemme zu verbinden, weiterhin aufweisend einen Analog-Digital-Umsetzer mit einem ersten Eingang, einem zweiten Eingang, und einen Ausgang zur Ausgabe des digitalen Messsignals, wobei der erste Kanal und der zweite Kanal jeweils zwei Anschlüsse zum Anschluss eines Messumformers aufweist, weiterhin aufweisend ein Mittel zur Drahtbruchprüfung, wobei das Mittel zur Drahtbruchprüfung folgendermaßen ausgestaltet ist, zwischen der ersten Eingangsklemme und der zweiten Eingangsklemme ist eine steuerbare Stromquelle angeordnet, dabei steht die Stromquelle mit einen Testsignalgenerator in Verbindung, welcher auf Basis eines digitalen Testsignals die Stromquelle derart steuert, dass die Stromquelle über die Eingangsklemmen ein analoges Sendesignal ausgibt, weiterhin aufweisend ein Signal-Analysemittel, welches einen ersten Analyseeingang und einen zweiten Analyseeingang aufweist, dabei ist auf dem ersten Analyseeingang das digitale Empfangssignal und auf dem zweiten Analyseeingang das digitale Testsignal geschaltet, das Signalanalysemittel ist ausgestaltet auf die an den Analyseeingängen anliegenden Signale eine Kreuzkorrelationsfunktion anzuwenden und einen Funktionswert zu ermitteln, weiterhin ist das Signalanalysemittel ausgestaltet anhand des Funktionswertes zu prüfen, ob das analoge Sendesignal in dem analogen Empfangssignal enthalten war, und für den Fall, dass das analoge Sendesignal nicht in dem analogen Empfangssignal enthalten war, ein Fehlersignal an ein Drahtbruchmeldemittel auszugeben.

In einer weiteren Ausgestaltung der Analog-Eingabebaugruppe ist die Stromquelle in einer Reihenschaltung mit einem Messwiderstand zwischen den Eingangsklemmen angeordnet, wobei der erste Eingang über ein Schaltmittel mit der ersten Eingangsklemme in Verbindung steht, dabei ist das Schaltmittel ausgestaltet, während einer Testphase zur Ausgabe des Sendesignals den ersten Eingang mit einen Mittenabgriff zwischen dem Messwiderstand und der Stromquelle zu verbinden und während einer Messphase den ersten Eingang mit der ersten Eingangsklemme zu verbinden.

Für eine Koordination zwischen einem Messen und einem Testen weist die Analog-Eingabebaugruppe eine Steuereinheit auf, welche ausgestaltet ist, das Schaltmittel entsprechend der Testphase oder der Messphase zu steuern.

Die eingangs genannte Aufgabe wird ebenfalls durch ein Verfahren zur Erkennung eines Drahtbruches von einer Leitung gelöst, wobei durch die Leitung zu einem Messumformer eine Mess-Schleife gebildet wird, ein digitales Testsignal erzeugt wird, das digitale Testsignal in ein analoges Sendesignal umgeformt und auf die Leitung aufgeprägt wird, und nach Durchlaufen des analogen Sendesignals durch die Mess-Schleife ein analoges Empfangssignal von der Leitung abgegriffen wird, das analoge Empfangssignal in ein digitales Empfangssignal umgeformt wird, ein Funktionswert durch Anwenden einer Kreuzkorrelationsfunktion auf das digitale Testsignal und das digitale Empfangssignal ermittelt wird, eine Prüfung anhand des Funktionswertes durchgeführt wird, ob das analoge Sendesignal in dem analogen Empfangssignal enthalten war, für den Fall, dass das analoge Sendesignal in dem analogen Empfangssignal nicht enthalten war, wird ein Fehlersignal ausgegeben. Mit Hilfe der Kreuzkorrelation kann insbesondere bei einem empfangenen Testsignal, welches beispielsweise durch Rauschen, Störungen oder Abschwächungen durch hochohmige Widerstände stark verfälscht ist, ein Testsignal in ein Empfangssignal wieder erkannt werden.

Mit Hilfe der Zeichnung wird die Erfindung näher erläutert. Es zeigt
- FIG 1: eine Schaltungsanordnung zum Umsetzen eines analogen Empfangssignals und ein digitales Empfangssignal,
- FIG 2: eine Analog-Eingabebaugruppe zur Umsetzung eines analogen Empfangssignals in ein digitales Empfangssignal,
- FIG 3: ein Sendesignal zum Testen,
- FIG 4: ein analoges Empfangssignal in dem vermutlich das Sendesignal enthalten ist und
- FIG 5: das Ergebnis einer Kreuzkorrelation des Sendesignals und des Empfangssignals.

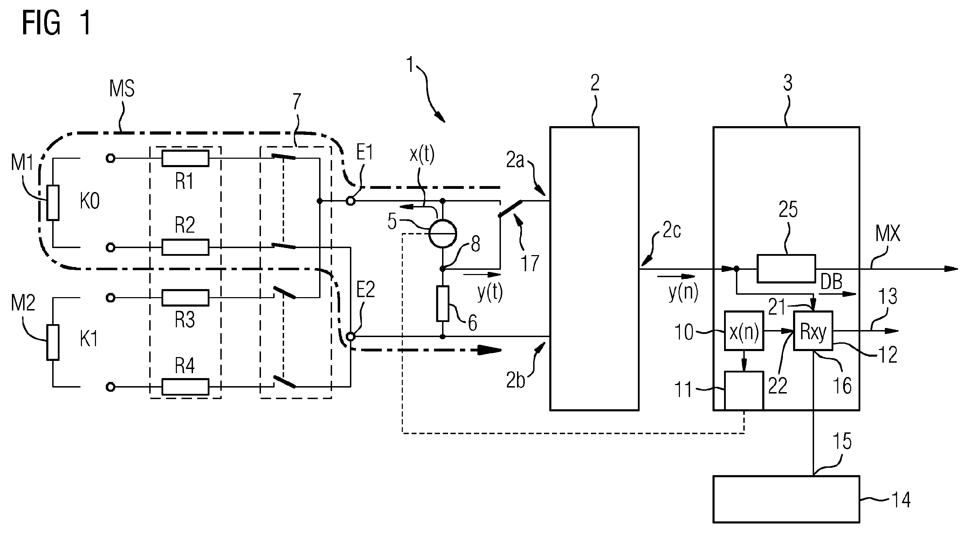

Gemäß FIG 1 ist eine Schaltungsanordnung 1 mit einem Analog-Digital-Wandler 2 zur Umsetzung eines analogen Empfangssignals y(t) in ein digitales Empfangssignal y(n) dargestellt. Um mit einer Schaltungsanordnung 1 möglichst mehrere unterschiedliche Signale von unterschiedlichen Messumformern M1,M2 auswerten zu können, ist der Schaltungsanordnung 1 eine Selektionsschaltung 7 vorgelagert. Die Selektionsschaltung 7 wird auch Multiplexer genannt. Da aufgrund heutiger Anforderungen an eine erhöhte Gleichtaktfestigkeit dem Multiplexer bzw. der Selektionsschaltung 7 Widerstände im Megaohm-Bereich vorgeschaltet sind, kann eine Drahtbrucherkennung durch eine herkömmliche Gleichstromprüfung nicht mehr erfolgen.

Die Schaltungsanordnung 1 weist eine erste Eingangsklemme E1 und eine zweite Eingangsklemme E2 zum Anschluss eines ersten Messumformers M1 bzw. eines zweiten Messumformers M2 auf. Zwischen der ersten Eingangsklemme E1 und der zweiten Eingangsklemme E2 ist eine steuerbare Stromquelle 5 angeordnet. Die steuerbare Stromquelle 5 steht mit einem Testsignalgenerator 10 in Verbindung, welche auf Basis eines digitalen Testsignals x(n) die Stromquelle 5 derart steuert, dass die Stromquelle 5 über die Eingangsklemmen E1,E2 ein analoges Sendesignal x(t) ausgibt.

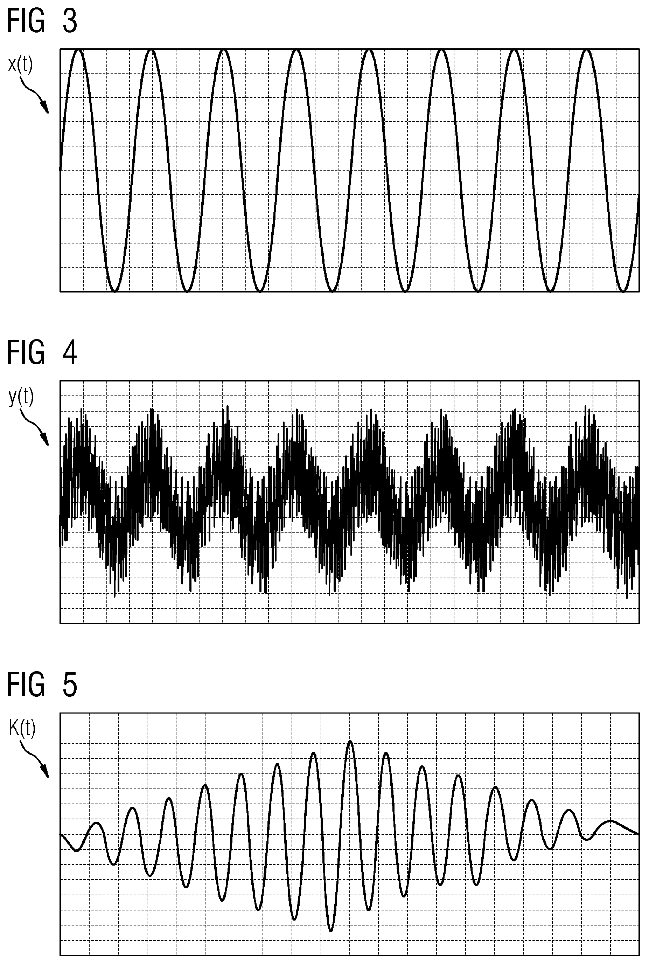

Für eine spätere Drahtbrucherkennung weist die Schaltungsanordnung 1 nun ein Signalanalysemittel 12 auf, welches einen ersten Analyseeingang 21 und einen zweiten Analyseeingang 22 aufweist. Auf den ersten Analyseeingang 21 ist das digitale Empfangssignal y(n) geschaltet und auf den zweiten Analyseeingang 22 ist das digitale Testsignal x(n) geschaltet. Das Signalanalysemittel 12 ist ausgestaltet, auf die an den Analyseeingängen 21,22 anliegenden Signale eine Kreuzkorrelationsfunktion R_{xy} anzuwenden und einen Funktionswert K(t) zu ermitteln und nun eine Drahtbruchprüfung mittels der Kreuzkorrelationsfunktion R_{xy} durchzuführen, ist das Signalanalysemittel 12 weiterhin ausgestaltet anhand des Funktionswertes K(t) zu prüfen, ob das analoge Sendesignal x(t) in dem analogen Empfangssignal y(t) enthalten war, und für den Fall, dass das analoge Sendesignal x(t) nicht in dem analogen Empfangssignal y(t) enthalten war, ein Fehlersignal DB auszugeben. Das Fehlersignal DB deutet dann auf einen Drahtbruch hin. Im Falle eines Drahtbruches sinkt die Amplitude des Funktionswertes K(t) stark ab und ändert seine Signalform. In einem einfachen Fall reicht eine Erkennung der Maximalamplitude des Funktionswertes K(t), welche der Maximalamplitude des Signals x(t) (FIG 3) entsprechen sollte.

Für ein Hin- und Herschalten zwischen einer Testphase und einer Messphase weist der Analog-Digital-Umsetzer 2 einen ersten Eingang 2a, einen zweiten Eingang 2b und einen Ausgang 2c auf und die Stromquelle 5 ist in einer Reihenschaltung mit einem Messwiderstand 6 zwischen den Eingangsklemmen E1,E2 angeordnet. Der erste Eingang 2a ist über ein Schaltmittel 17 über der ersten Eingangsklemme E1 verbunden, dabei ist das Schaltmittel 17 dazu ausgestaltet während einer Testphase zur Ausgabe des analogen Sendesignals x(t) den ersten Eingang 2a mit dem Mittenabgriff 8 zwischen dem Messwiderstand 6 und der Stromquelle 5 zu verbinden und während einer Messphase, bei welcher Messwerte MX des Messumformers M1 bzw. des Messumformers M2 ermittelt werden, den ersten Eingang 2a mit der ersten Eingangsklemme E1 zu verbinden.

Für das Hin- und Herschalten zwischen einer Messphase und einer Testphase weist die Schaltungsanordnung 1 eine Steuereinheit 14 auf, welche ausgestaltet ist, das Schaltmittel 17 entsprechend der Testphase oder der Messphase zu steuern.

Ein Multiplexer bzw. die Selektionsschaltung 7 kann für eine Mehrkanaligkeit ausgelegt werden und ist damit ausgestaltet, einen ersten Kanal K0 oder einen zweiten Kanal K1 mit den Eingangsklemmen E1,E2 zu verbinden.

Zwischen der Schaltungsanordnung 1 bzw. den Ausgängen des Multiplexers, nämlich der Selektionsschaltung 7, führen zu dem ersten Messumformer M1 und dem zweiten Messumformer M2 jeweils eine Leitung. Diese Leitung gilt es auf Drahtbruch zu testen. Die Leitung zu einen Messumformer M1,M2 bildet eine Mess-Schleife MS. Durch diese Mess-Schleife MS wird ein analoges Sendesignal x(t) geschickt. Nach Durchlaufen des analogen Sendesignals x(t) durch die Mess-Schleife MS kann wiederum ein analoges Empfangssignal y(t) von der Leitung über die Eingangsklemmen E1,E2 abgegriffen werden.

Das analoge Empfangssignal y(t) wird in ein digitales Empfangssignal y(n) umgeformt und über den ersten Analyseeingang 21 dem Signalanalysemittel 12 zugeführt. Das analoge Sendesignal x(t) wurde aus einem digitalen Testsignal x(n) generiert. Auch das digitale Testsignal x(n) wird über den zweiten Analyseeingang 22 dem Signalanalysemittel 12 zugeführt, in welchen eine Kreuzkorrelation auf die beiden Signale angewendet wird.

Das Ergebnis der Kreuzkorrelation entspricht einen Funktionswert K(t) (siehe FIG 5) an welchem abgeleitet werden kann, ob ein Drahtbruch vorliegt oder nicht.

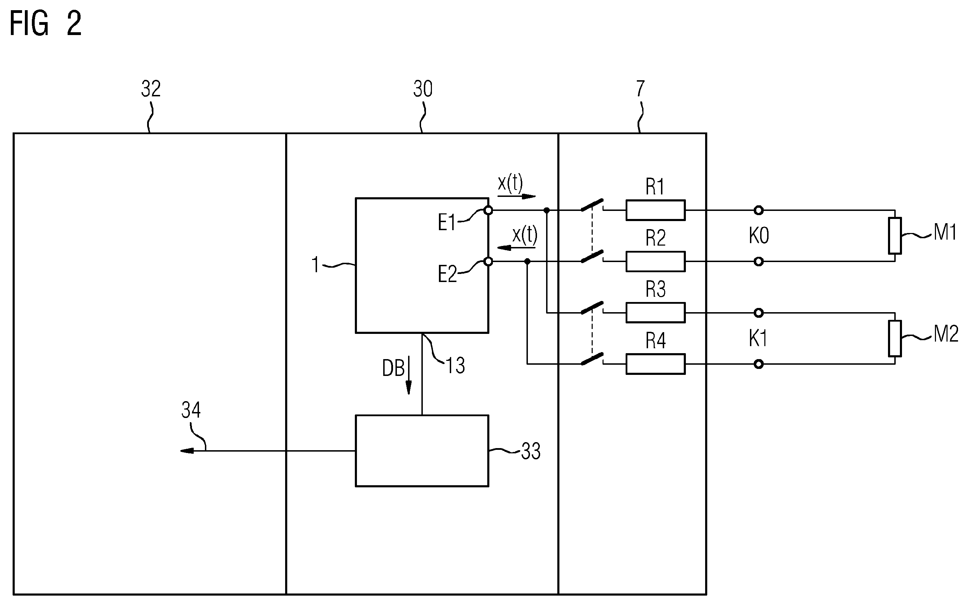

Mit der FIG 2 ist eine Analog-Eingabebaugruppe 30 zur Umsetzung eines analogen Empfangssignals x(t) in ein digitales Empfangssignal y(n) mit einer Selektionsschaltung 7 dargestellt. Die Selektionsschaltung 7 entspricht wiederum einem Multiplexer, welcher es ermöglicht, einer einzigen Schaltungsanordnung 1 mehrere Messumformer M1,M2 zuzuordnen. Da heutige Analog-Eingabebaugruppen eine erhöhte Forderung an eine Gleichtaktfestigkeit haben, welches bedeutet, dass sich zwischen den einzelnen Kanälen K0,K1 bzw. den zu den Messumformern führenden Leitungen keine hohen Spannungsunterschiede bzw. Potentialausgleichsvorgänge beim Umschalten zwischen den Kanälen K0,K1 bemerkbar machen sollen, sind dem Multiplexer hochohmige Widerstände R1,R2,R3,R4 vorgeschaltet.

Die Analog-Eingabebaugruppe 30 ist an ein Automatisierungsgerät 32, insbesondere eine speicherprogrammierbare Steuerung, angeschlossen. Für eine Erkennung eines Drahtbruches einer Leitung zu einem Messumformer M1,M2 weist die Analog-Eingabebaugruppe 30 ein Drahtbruchmeldemittel 33 auf, welches ausgestaltet ist, eine Drahtbruchmeldung 34 an das Automatisierungsgerät 32 weiterzuleiten.

Der in der Schaltungsanordnung 1 aufgezeigte Detektionsausgang 13 (siehe auch FIG 1) generiert ein Fehlersignal DB, welches an das Drahtbruchmittel 33 der Analog-Eingabebaugruppe 30 weitergeleitet wird.

FIG 3 zeigt einen Signalverlauf eines analogen Sendesignals x(t), welches als Testsignal der Leitung zu einem Messumformer M1,M2 aufgeprägt wird.

Die FIG 4 zeigt ein analoges Empfangssignal y(t), welches nach Aufprägen des Sendesignals x(t) auf die Leitung von der Leitung zurückgelesen wurde.

Die FIG 5 zeigt den Signalverlauf eines Funktionswertes K(t) welcher durch eine Kreuzkorrelationsfunktion R_{xy} der Signale x(t) (FIG 3) und y(t) (FIG 4) gewonnen wurde. Anhand einer maximalen Amplitude des Funktionswertes K(t) des Signalverlaufes des Funktionswertes K(t) kann aus dem Signalverlauf des Funktionswertes K(t) abgelesen werden, dass das Signal x(t) in dem zurückgelesenen Empfangssignal y(t) enthalten war und somit kein Drahtbruch vorliegt, denn die Leitung ist intakt.

## Patentansprüche

1. Schaltungsanordnung (1) mit einem Analog-Digital-Umsetzer (2) zur Umsetzung eines analogen Empfangssignals (y(t)) in ein digitales Empfangssignal (y(n)), weiterhin aufweisend eine erste Eingangsklemme (E1) und eine zweite Eingangsklemme (E2) zum Anschluss eines Messumformers (M1,M2), wobei zwischen der ersten Eingangsklemme (E1) und der zweiten Eingangsklemme (E2) eine steuerbare Stromquelle (5) angeordnet ist, dabei steht die Stromquelle (5) mit einem Testsignalgenerator (10) in Verbindung, welcher auf Basis eines digitalen Testsignals (x(n)) die Stromquelle (5) derart steuert, dass die Stromquelle (5) über die Eingangsklemmen (E1,E2) ein analoges Sendesignal (x(t)) ausgibt, weiterhin aufweisend ein Signalanalysemittel (12), welches einen ersten Analyseeingang (21) und einen zweiten Analyseeingang (22) aufweist, dabei ist auf den ersten Analyseeingang (21) das digitale Empfangssignals (y(n)) und auf den zweiten Analyseeingang (22) das digitale Testsignal (x(n)) geschaltet, das Signalanalysemittel (12) ist ausgestaltet auf die an den Analyseeingängen (21,22) anliegenden Signale eine Kreuzkorrelationsfunktion (R_{xy}) anzuwenden und einen Funktionswert (K(t)) zu ermitteln, weiterhin ist das Signalanalysemittel (12) ausgestaltet an Hand des Funktionswertes (K(t)) zu prüfen, ob das analoge Sendesignal (x(t)) in dem analogen Empfangssignal (Y(t)) enthalten war, und für den Fall, dass das analoge Sendesignal (x(t)) nicht in dem analogen Empfangssignal (Y(t)) enthalten war, ein Fehlersignal (DB) auszugeben.

2. Schaltungsanordnung (1) nach Anspruch 1, wobei der Analog-Digital-Umsetzer (2) einen ersten Eingang (2a), einen zweiten Eingang (2b) und einen Ausgang (2c) aufweist und die Stromquelle (5) in einer Reihenschaltung mit einem Messwiderstand (6) zwischen den Eingangsklemmen (E1,E2) angeordnet ist, wobei der erste Eingang (2a) über ein Schaltmittel (17) mit der ersten Eingangsklemme (E1) in Verbindung steht, dabei ist das Schaltmittel (17) ausgestaltet während einer Testphase zur Ausgabe des analogen Sendesignals (x(t)) den ersten Eingang (2a) mit einem Mittenabgriff (8) zwischen dem Messwiderstand (6) und der Stromquelle (5) zu verbinden und während einer Messphase, bei welcher Messwerte (MX) des Messumformers (M1,M2) ermittel werden, den ersten Eingang (2a) mit der ersten Eingangsklemme (E1) zu verbinden.

3. Schaltungsanordnung (1) nach Anspruch 2, weiterhin aufweisend eine Steuereinheit (14), welche ausgestaltet ist das Schaltmittel (17) entsprechend der Testphase oder der Messphase zu steuern.

4. Schaltungsanordnung (1) nach einem der Ansprüche 1 bis 3, wobei an die Eingangsklemmen (E1,E2) eine Selektionsschaltung (7) angeschlossen ist, welche ausgestaltet ist einen ersten Kanal (K0) oder einen zweiten Kanal (K1) mit den Eingangsklemmen (E1,E2) zu verbinden.

5. Analog-Eingabebaugruppe (30) zur Umsetzung eines analogen Empfangssignals (y(t)) in ein digitales Empfangssignal (y(n)) mit einer Selektionsschaltung (7), welche ausgestaltet ist einen ersten Kanal (K0) oder einen zweiten Kanal (K1) mit jeweils einer ersten Eingangsklemme (E1) und einer zweiten Eingangsklemme (E2) zu verbinden, aufweisend einen Analog-Digital-Umsetzer (2) mit einem ersten Eingang (2a), einem zweiten Eingang (2b) und einen Ausgang (2c) zur Ausgabe des digitalen Messsignals (y(n)), wobei der erste Kanal (K0) und der zweite Kanal (K1) jeweils zwei Anschlüsse zum Anschluss eines Messumformers (M1,M2) aufweist, weiterhin aufweisend ein Mittel zur Drahtbruchprüfung,
**dadurch gekennzeichnet, dass** das Mittel zur Drahtbruchprüfung folgendermaßen ausgestaltet ist, zwischen der ersten Eingangsklemme (E1) und der zweiten Eingangsklemme (E2) ist eine steuerbare Stromquelle (5) angeordnet, dabei steht die Stromquelle (5) mit einem Testsignalgenerator (10) in Verbindung, welcher auf Basis eines digitalen Testsignals (x(n)) die Stromquelle (5) derart steuert, dass die Stromquelle (5) über die Eingangsklemmen (E1,E2) ein analoges Sendesignal (x(t)) ausgibt, weiterhin aufweisend ein Signalanalysemittel (12) welches einen ersten Analyseeingang (21) und einen zweiten Analyseeingang (22) aufweist, dabei ist auf den ersten Analyseeingang (21) das digitale Empfangssignal (y(n)) und auf den zweiten Analyseeingang (22) das digitale Testsignal (x(n)) geschaltet, das Signalanalysemittel (12) ist ausgestaltet auf die an den Analyseeingängen (21,22) anliegenden Signale eine Kreuzkorrelationsfunktion (R_{xy}) anzuwenden und einen Funktionswert (K(t)) zu ermitteln, weiterhin ist das Signalanalysemittel (12) ausgestaltet an Hand des Funktionswertes (K(t)) zu prüfen, ob das analoge Sendesignal (x(t)) in dem analogen Empfangssignal (Y(t)) enthalten war, und für den Fall, dass das analoge Sendesignal (x(t)) nicht in dem analogen Empfangssignal (Y(t)) enthalten war, ein Fehlersignal (DB) an ein Drahtbruchmeldemittel (33) auszugegeben.

6. Analog-Eingabebaugruppe (30) nach Anspruch 5, wobei die Stromquelle (5) in einer Reihenschaltung mit einem Messwiderstand (6) zwischen den Eingangsklemmen (E1,E2) angeordnet ist, wobei der erste Eingang (2a) über ein Schaltmittel (17) mit der ersten Eingangsklemme (E1) in Verbindung steht, dabei ist das Schaltmittel (17) ausgestaltet während einer Testphase zur Ausgabe des Sendesignals (x(t)) den ersten Eingang (2a) mit einem Mittenabgriff (8) zwischen dem Messwiderstand (6) und der Stromquelle (5) zu verbinden und während einer Messphase den ersten Eingang (2a) mit der ersten Eingangsklemme (E1) zu verbinden.

7. Analog-Eingabebaugruppe (30) nach Anspruch 6, weiterhin aufweisend eine Steuereinheit (14), welche ausgestaltet ist das Schaltmittel (17) entsprechend der Testphase oder der Messphase zu steuern.

8. Verfahren zur Erkennung eines Drahtbruchs von einer Leitung, wobei
- durch die Leitung zu einem Messumformer (M1,M2) eine Mess-Schleife (MS) gebildet wird,
- ein digitales Testsignal (x(n)) erzeugt wird,
- das digitale Testsignal (x(n)) in ein analoges Sendesignal (x(t)) umgeformt und auf die Leitung aufgeprägt wird, und
- nach Durchlaufen des analogen Sendesignals (x(t)) durch die Mess-Schleife (MS), ein analoges Empfangssignal (Y(t)) von der Leitung abgegriffen wird,
- dass analoge Empfangssignal (Y(t)) in ein digitales Empfangssignal (Y(n)) umgeformt wird,
- ein Funktionswert (K(t)) durch Anwenden einer Kreuzkorrelationsfunktion (R_{xy}) auf das digitale Testsignal (x (n) ) und das digitales Empfangssignal (Y(n)) ermittelt wird,
- eine Prüfung an Hand des Funktionswertes (K(t)) durchgeführt wird, ob das analoge Sendesignal (x(t)) in dem analogen Empfangssignal (Y(t)) enthalten war, für den Fall, dass das analoge Sendesignal (x(t)) in dem analogen Empfangssignal (Y(t)) nicht enthalten war, wird ein Fehlersignal (DB) ausgegeben.
